Europäisches Patentamt

European Patent Office

Office européen des brevets

(19)

(11) **EP 0 739 501 B1**

(12) **EUROPÄISCHE PATENTSCHRIFT**

(45) Veröffentlichungstag und Bekanntmachung des Hinweises auf die Patenterteilung:
**28.10.1998 Patentblatt 1998/44**

(21) Anmeldenummer: **94916140.0**

(22) Anmeldetag: **28.05.1994**

(51) Int Cl.6: **G05B 19/23, H02P 8/22**

(86) Internationale Anmeldenummer:
**PCT/DE94/00606**

(87) Internationale Veröffentlichungsnummer:
**WO 95/18994 (13.07.1995 Gazette 1995/30)**

(54) **KORREKTURVERFAHREN ZWISCHEN DEM ELEKTRISCHEN PHASENWINKEL UND DEM MECHANISCHEN ABTRIEBSWINKEL EINES SCHRITTMOTORS**

CORRECTION PROCESS BETWEEN THE ELECTRIC PHASE ANGLE AND MECHANICAL OUTPUT ANGLE OF A STEP MOTOR

PROCEDE DE CORRECTION ENTRE L'ANGLE DE PHASE ELECTRIQUE ET L'ANGLE DE SORTIE MECANIQUE D'UN MOTEUR PAS A PAS

(84) Benannte Vertragsstaaten:
**CH DE ES FR GB IT LI SE**

(30) Priorität: **11.01.1994 DE 4400482**

(43) Veröffentlichungstag der Anmeldung:
**30.10.1996 Patentblatt 1996/44**

(73) Patentinhaber: **ROBERT BOSCH GMBH 70442 Stuttgart (DE)**

(72) Erfinder:
- **RAUCH, Hans D-90768 Fuerth (DE)**
- **HOVESTADT, Uwe D-91161 Hilpoltstein (DE)**
- **HERZOG, Bernhard D-70619 Stuttgart (DE)**
- **EHRMANN, Martin D-90459 Nürnberg (DE)**

(56) Entgegenhaltungen:
EP-A- 0 189 794          EP-A- 0 571 759
WO-A-91/07009          DE-A- 2 850 539

- **PATENT ABSTRACTS OF JAPAN vol. 14, no. 451 (E-0984) 27. September 1990 & JP,A,02 179 298 (MATSUSHITA ELECTRIC IND CO LTD) 12. Juli 1990**
- **PATENT ABSTRACTS OF JAPAN vol. 9, no. 227 (P-388) 13. September 1985 & JP,A,60 085 474 (HITACHI SEISAKUSHO KK) 14. Mai 1985**
- **PATENT ABSTRACTS OF JAPAN vol. 16, no. 534 (M-1334) 4. November 1992 & JP,A,04 201 059 (NISSAN MOTOR CO LTD) 22. Juli 1992**
- **SOVIET PATENTS ABSTRACTS Section EI, Week 8724, 24. Juni 1987 Derwent Publications Ltd., London, GB; Class T06, AN 87-169510 & SU,A,1 267 360 (AS UKR HARDMATERIALS) 30. Oktober 1986**
- **PATENT ABSTRACTS OF JAPAN vol. 12, no. 293 (E-645) 10. August 1988 & JP,A,63 069 497 (MATSUSHITA ELECTRIC IND CO) 29. März 1988**

**Beschreibung**

Stand der Technik

Die Erfindung geht aus von einem Verfahren zur Mikroschrittsteuerung, wie es beispielsweise bereits aus der EP 0 571 759 A2 bekannt ist.

Bei der bekannten Mikroschrittsteuerung für einen Schrittmotor, insbesondere einen Permanent-Schrittmotor wird die Drehbewegung des Schrittmotors durch eine Vielzahl von Mikroschritten erzeugt. Dabei werden die Mikroschritte mit einzelnen Stromimpulsen erzeugt, deren Anzahl und Amplitude derart ausgebildet ist, daß der Schrittmotor eine quasi sinusförmige Ansteuerkurve im arithmetischen Mittel enthält. Die einzelnen Mikroschritte des Schrittmotors werden erfaßt bzw. gezählt und damit ist die augenblickliche Istposition der Motorwelle der Steuerung bekannt. Folgt der Rotor des Schrittmotors nicht der vorgegebenen Sollposition, dann ist auf einfache Weise eine entsprechende Korrektur möglich. Durch die Kontrolle der Istposition des Schrittmotors wird der Rundlauf verbessert, so daß insbesondere bei der Verwendung des Schrittmotors für die Anzeige in einer Instrumententafel keine störenden ruckartigen Bewegungen auftreten.

Für den Antrieb von Zeigerinstrumenten, speziell in Fahrzeugen, wurden bislang neben mechanischen Tachometern, Bimetallinstrumenten und Drehspulinstrumenten vorwiegend Drehmagnet-Quotienten-Meßwerke (DQM) eingesetzt. In neuerer Zeit setzen sich jedoch - speziell in Europa - Schrittmotoren (2-Phasig) als Zeigerantrieb immer mehr durch. Solche Schrittmotoren werden sowohl als Direktantriebe (NMB) wie auch - bevorzugt - als Getriebemotoren (Hersteller switec und VDO) eingesetzt.

Für Direktantriebe werden aus Drehmoment- und Kostengründen bislang ausschließlich Klauenpol(Tin-Can-) Schrittmotoren eingesetzt. Diese Motoren erfordern bei Schrittwinkeln von typisch 7,5° bis 15° für die benötigte Auflösung von ca. 0,1° eine Ansteuerung im Mikroschritt-Betrieb. Die derzeit in großen Stückzahlen gefertigten Standard-Typen haben allerdings einen stark nichtlinearen Zusammenhang zwischen elektrischem Phasenwinkel und mechanischem Abtriebswinkel, so daß die klassische Sinus-Ansteuerung einen völlig indiskutablen, ruckelnden Zeigerlauf ergibt. Die Ursache hierfür liegt - unter anderem - im mechanischen Rastmoment der Motoren.

Es existieren nun speziell optimierte Typen, die auch mit Sinus-Ansteuerung akzeptable Gleichlauf-Eigenschaften aufweisen. Diese Motoren haben allerdings bei erhöhtem konstruktiven Aufwand schlechtere mechanische Kenndaten als die entsprechenden Standard-Typen. Dennoch ist das Verhalten über den Temperatur- und Spannungsbereich nicht vollständig zufriedenstellend. Außerdem benötigen sie für die Nullstellung bzw. Positionskontrolle zusätzliche Sensoren, z. B. einen Hall-IC.

Vorteile der Erfindung

Das erfindungsgemäße Verfahren zur Ansteuerung eines Schrittmotors mit den kennzeichnenden Merkmalen des Hauptanspruchs hat demgegenüber den Vorteil, daß durch die Korrektur der Ansteuerimpulse ein besonders einfacher Encoder (digitaler Winkelgeber) aus dem 'lowest-cost'-Bereich verwendbar ist und somit nicht viel mehr kostet als ein Null-Sensor, der die Null-Lage des Schrittmotors erfaßt. Neben der Null-Stellung kann somit auch die Bewegungskontrolle des Schrittmotors erfaßt und vor allem auch zur Korrektur des Mikroschritt-Verhaltens verwendet werden, wobei die erforderliche Auflösung weit unter der liegt, die bei klassischen Regelverfahren erforderlich ist. Dadurch gelingt es, den Schrittmotor beispielsweise mit einer Auflösung von 0,1° anzusteuern, obgleich der verwendete Winkelgeber diese hohe Auflösung nicht nachmessen kann.

Durch die in den abhängigen Ansprüchen aufgeführten Maßnahmen sind vorteilhafte Weiterbildungen und Verbesserungen des im Hauptanspruch angegebenen Verfahrens möglich.

Zeichnung

Ein Ausführungsbeispiel der Erfindung ist in der Zeichnung dargestellt und in der nachfolgenden Beschreibung näher erläutert. Es zeigen Figur 1 ein erstes Blockschaltbild nach dem Stand der Technik, Figur 2 zeigt ein erstes Diagramm, Figur 3 zeigt ein zweites Diagramm, Figur 4 zeigt ein zweites Blockschaltbild, Figur 5 zeigt ein drittes Blockschaltbild, Figur 6a und b zeigt jeweils ein zweites Diagramm, Figur 7 zeigt ein viertes Blockschaltbild, Figur 8 zeigt ein fünftes Blockschaltbild, Figur 9 zeigt ein drittes Diagramm, Figur 10 zeigt ein viertes Diagramm und Figur 11 ein fünftes Diagramm.

Beschreibung des Ausführungsbeispiels

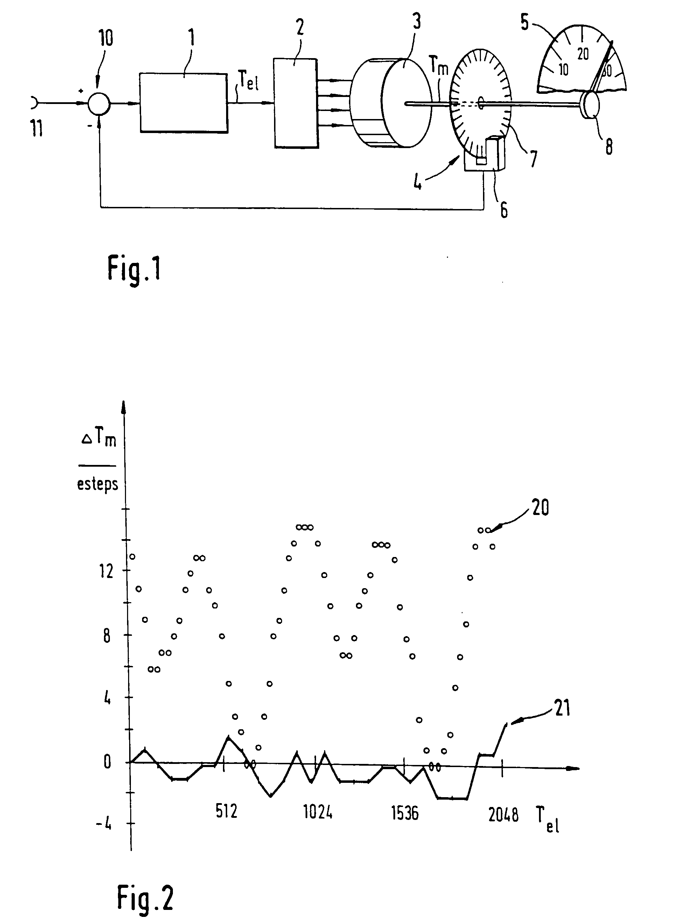

Das erste Blockschaltbild nach Figur 1 zeigt einen bekannten Schrittmotor 3, auf dessen Welle ein Encoder oder Winkelgeber 4 fest angeordnet ist. Der Winkelgeber 4 hat eine feststehende Lichtschranke 6, an der die Markierung

EP 0 739 501 B1

einer Code-Scheibe 7, die mit der Welle des Ankers des Schrittmotors 3 fest verbunden ist, vorbeiläuft. Auf der Welle ist beispielsweise noch ein Zeiger 8 für ein Anzeigeinstrument befestigt, der einer feststehenden Skalenscheibe 5 zugeordnet ist. Das Anzeigeinstrument kann in einer Instrumententafel eines Kraftfahrzeuges angebracht sein. Der Schrittmotor 3 wird von einer Endstufe 2 mit Stromimpulsen versorgt, die von einer vorgeschalteten Steuerung 1 erzeugt werden. Die bekannte Steuerung 1 vergleicht an einem Punkt 10 einen Sollwert 11 mit den vom Winkelgeber 4 gemessenen Wert und steuert oder regelt damit den Strom für die Endstufe 2. Dieses Blockschaltbild entspricht dem bekannten Regelverfahren für die Ansteuerung eines Schrittmotors im Mikroschritt-Betrieb.

Figur 2 zeigt ein erstes Diagramm, bei dem die Differenz $\Delta T_m$ zwischen dem tatsächlichen und dem idealen mechanischen Winkel T in Form von relativen Schritten über dem elektrischen Winkel $T_{el}$ aufgetragen ist. Bei einer nicht korrigierten Kurve 20 ist erkennbar, daß die Differenz der einzelnen Phasenwinkel $T_{el}$ relativ groß ist. Bei der korrigierten Kurve 21, bei der die Korrektur mittels vier bis fünf Fourier-Koeffizienten durchgeführt wurde, nur eine sehr geringe Differenz auftritt.

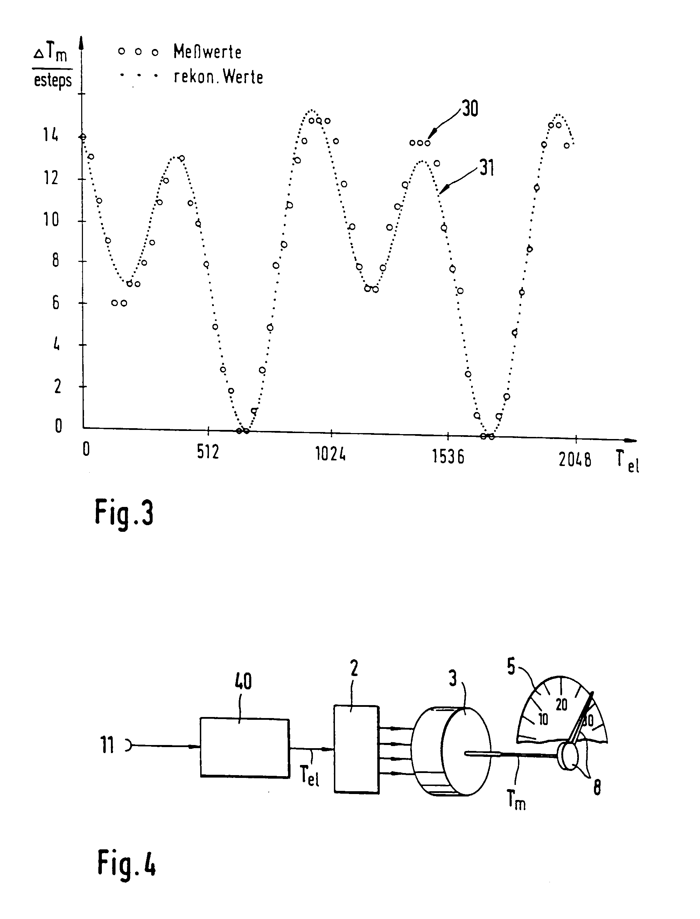

Figur 3 zeigt ein zweites Diagramm, bei dem eine gemessene Kennlinie 30 für Winkelfehler $\Delta T$ m mit einer rekonstruierten Kennlinie 31 verglichen wird, die anhand der vier Fourier-Koeffizienten $a_2$, $b_2$, $a_4$, $b_4$ ermittelt wurde.

Figur 4 zeigt als erstes Ausführungsbeispiel der Erfindung ein zweites Blockschaltbild für den Schrittmotor 3, bei dem die Steuerung eine Korrekturstufe 40 hat. In der Korrekturstufe 40 sind die ermittelten Fourier-Koeffizienten nach der vereinfachten Fourier-Synthese gebildet, deren Gewinnung später noch erläutert wird.

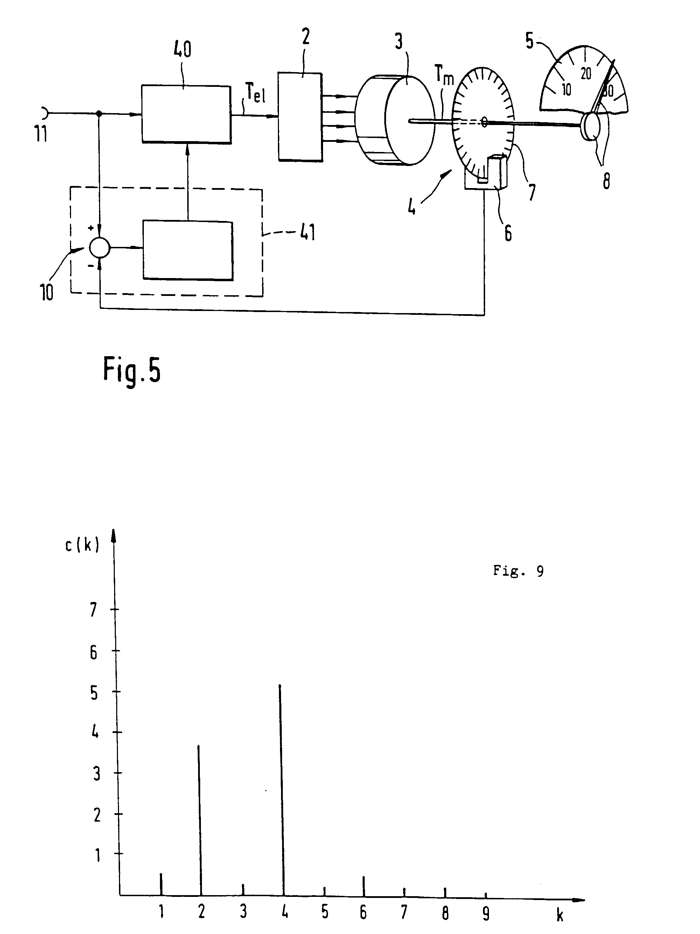

Figur 5 zeigt ein drittes Blockschaltbild, bei dem das Blockschaltbild der Figur 4 um eine adaptive Koeffizientenanpassung 41 ergänzt wird. In dem Summenpunkt 10 werden die Signale des Winkelgebers 4 mit Sollwerten 11 verglichen. Entsprechend dem Ergebnis werden aus dem Koeffizientenspeicher laufend aktuelle Werte ausgelesen, die zur Korrektur in die Korrekturstufe 40 gegeben werden.

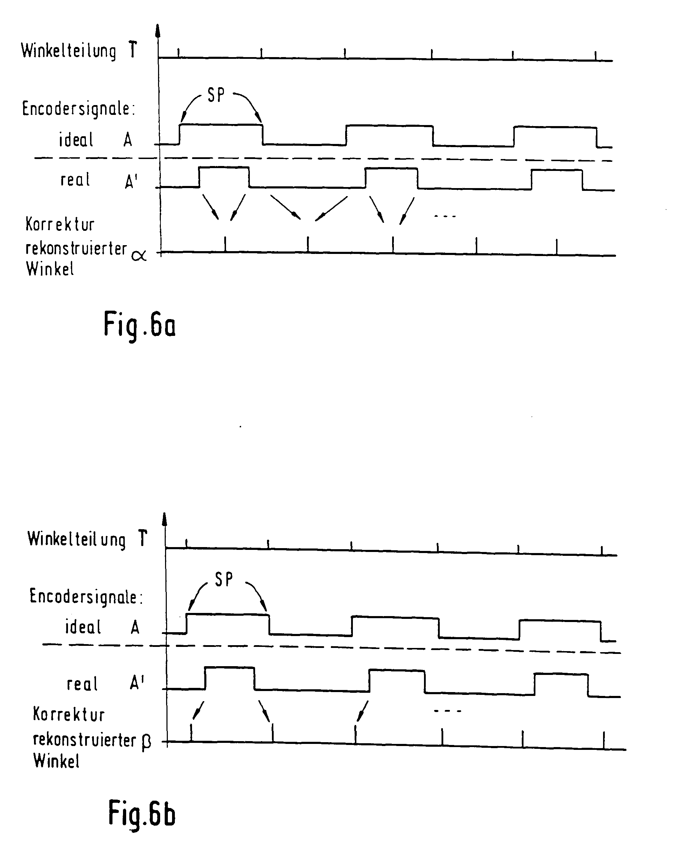

Figur 6a zeigt ein zweites Diagramm, bei dem die Bildung von Korrekturwerten dargestellt ist. Die oberste Kurve entspricht der Winkelteilung auf der Codescheibe 7 des Winkelgebers 4. Der Winkelgeber 4 gibt dabei ideale bzw. reale Signale ab, die den beiden darunter dargestellten Kurven entsprechen. In der nächsten Kurve werden aus den gemessenen Signalen des Winkelgebers 4 Korrekturwerte gebildet, die später noch näher erläutert sind. Sie führen über die realen Signale schließlich zu Korrekturwerten, wie sie in der untersten Kurve dargestellt sind.

Im folgenden wird die Funktionsweise des Korrekturverfahrens näher erläutert.

Dem erfindungsgemäßen Verfahren liegt die Annahme zugrunde, daß ein einfacher (evtl. einkanaliger) Encoder (digitaler Winkelgeber) nicht sehr viel mehr Kosten verursacht als ein üblicher Null-Sensor. Er kann jedoch außer zur Nullstellung noch zur Bewegungskontrolle genutzt werden (Eigendiagnose) und vor allem auch zur Korrektur des Mikroschritt-Verhaltens, wobei die erforderliche Auflösung weit unter der liegt, die bei klassischem Regelverfahren (Grundstruktur entsprechend Fig. 1) erforderlich ist.

Aus der geringen Winkelauflösung von "Lowest-Cost"-Encodern ergibt sich zwingend, daß bei langsamen Stellvorgängen die Encoder-Pulse eine wesentlich zu große Periodendauer haben, um als Winkelsignal für eine klassische Regelung zu dienen. Als Abhilfe sind folgende Verfahren denkbar.

A. Erhöhung der Auflösung durch analoge Auswertung der Encoder-Signale entsprechend dem Stand der Technik bei hochwertigen Glasmaßstäben. Dies erfordert eine A/D-Wandlung der Signale und zusätzlich entweder einen relativ genauen Geber oder eine aufwendige (digitale) Korrektur der Signale.

Das Encoder-Signal dient dabei nur zur adaptiven Nachführung von Parametern, die die Art der Korrektur beeinflussen, und ist daher bezüglich Zeit- und Winkelauflösung sehr unkritisch. Auch genügt für ein solches Verfahren (im Gegensatz zu A und B) eventuell ein Encoder mit nur einem einzigen Kanal. Als Nachteil ist jedoch anzusehen, daß Störungen der Regelstrecke nur insoweit ausgeglichen werden können, wie sie von den Korrektur-Parametern erfaßt werden können. Dies gilt zwar relativ gut für

- die eingangs erwähnten, elektromagnetisch bedingten Nichtlinearitäten

- Unwucht-bedingte Winkelabweichungen

jedoch nicht für

- stochastische Störungen (z. B. Stick-Slip-Verhalten)

- lokale Störungen ("Hänger")

Die vorliegende Erfindung entspricht dem Verfahren C. Nach den bisherigen Erfahrungen mit Schrittmotor-Direktantrieben dominieren die periodischen Nichtlinearitäten gegenüber allen anderen Störeinflüssen bei weitem, so daß auf eine Ausregelung der anderen Störungen durchaus verzichtet werden kann.

Anhand eines Ausführungsbeispiels wird belegt, daß der Fehler eines einzelnen Antriebs mit nur 4 bis 5 Fourier-

3

koeffizienten ausreichend genau zu beschreiben ist, so daß nur ein sehr geringer Speicherbedarf (RAM) für Koeffizienten benötigt wird.

1. Es wurden zunächst Messungen der tatsächlich auftretenden Winkelabweichungen von zweiphasigen Klauenpol-Schrittmotoren mit einer anschließenden Fourier-Analyse durchgeführt. Als Ergebnis ist festzustellen, daß bei diesen Abweichungen die 4. Harmonische der Ansteuerfrequenz stark dominiert (bezogen auf elektrische Zyklen, die 4. Harmonische entspricht also der Schrittfrequenz). Diese Abweichungen entsprechen dem Verlauf des Rastmomentes. Eine weitere meßbare Abweichung entspricht der 2. harmonischen Zyklen-Frequenz (halbe Schrittfrequenz), wohl verursacht durch Unsymmetrien zwischen den beiden Magnetkreisen.

Zur Korrektur der so ermittelten periodischen Abweichungen werden demnach nur 4 Fourier-Koeffizienten ($a_2$, $b_2$, $a_4$, $b_4$) benötigt.

Fig. 3 zeigt beispielhaft eine gemessene Kennlinie (Winkelfehler $\Delta T_m$ über Absolutwinkel $T_{el}$) und die rekonstruierte Kennlinie anhand der ermittelten 4 Fourier-Koeffizienten.

2. Harmonische Korrektur als klassische Steuerung

Diese Koeffizienten können nun z. B. bei der Montage bzw. Kontrolle eines elektromechanischen Systems einmalig bestimmt werden und in die Ansteuerung einprogrammiert werden (Fig. 4). Der Vorteil dieser Vorgehensweise ist, daß die Winkelerfassung nicht notwendigerweise in jedes gefertigte System eingebaut werden muß, sondern kostengünstig vorzugsweise nur einmalig in der Prüfeinrichtung. Als Nachteil steht dem jedoch gegenüber, daß Drifts in den tatsächlichen Koeffizienten (Temperatur, Versorgungsspannung, Alterung) nicht erfaßt werden können.

3. Harmonische Korrektur als adaptive Steuerung

Bei der adaptiven Ausführung für jedes einzelne System ist mindestens ein einfacher Encoder erforderlich (Fig. 5). Das System ist dann mit der geeigneten Software in der Lage, die Koeffizienten selbst anzupassen, wofür in der Praxis maximal eine Zeigerumdrehung erforderlich ist. Sämtliche Drifts der periodischen Störungen werden dann ständig erfaßt und die Korrektur-Koeffizienten entsprechend angepaßt; dadurch ergibt sich eine über die Lebensdauer optimale Korrektur. Über die Auswertung der ständig erfaßten Abweichungen ist vorteilhaft eine gewisse Eigendiagnose des Systems möglich.

Der Encoder kann gleichzeitig für die Detektion des Nullpunktes genutzt werden, z. B. in Verbindung mit einem Anschlag.

4. Korrektur der Hysterese

Der beschriebene Schrittmotor-Typ hat prinzipbedingt eine gewisse Hysterese, typisch etwa 1°. Diese Hysterese kann bei beiden Korrektur-Prinzipien berücksichtigt werden, wobei eine eventuelle Überkompensation bei der klassischen Steuerung zu extrem unruhigem Zeigerlauf führt. Bei der adaptiven Steuerung kann auch die Hysterese ständig nachgemessen und entsprechend korrigiert werden.

In jedem Fall könnte es zweckmäßig sein, die reale Abhängigkeit der Hysterese vom Reversierwinkel - bedingt durch die magnetische Hysterese - durch ein einfaches mathematisches Modell nachzubilden.

5. Praktische Realisierungsmöglichkeiten

Die beschriebenen Korrekturverfahren wurden für einen Mikrocontroller programmiert und in Verbindung mit einer Pulsweitenmudulation (PWM-Ansteuerung) für die Ansteuerung des Schrittmotors verwendet. Für die Umsetzung der Verfahren mit der begrenzten Rechenleistung preiswerter Prozessoren empfehlen sich einige softwareseitige Maßnahmen:

- Abbildung der Abweichungen und Korrekturkoeffizienten auf Integer-Größen mit max. 8 bit Wortbreite durch geeignete Skalierung

- Berechnung der Winkelfunktionen über entsprechende Tabellen

- Berechnung der Fourier-Koeffizienten und daraus der Korrekturwerte für einen kompletten elektrischen Zyklus nur in größeren Zeit- bzw. Winkelintervallen (z. B. 100 ms oder 15°), Ablegen der Korrekturwerte in einer Tabelle

- evtl. lineare Interpolation innerhalb bestimmter Winkelbereiche

- Bei großen Winkelgeschwindigkeiten kann die adaptive Komponente deaktiviert werden. Damit wird zum einen Rechenzeit gespart, die mit steigender Winkelgeschwindigkeit zunehmend kritisch wird; zum anderen ist die Gültigkeit der statischen Korrektur-Kennlinie bei hohen Winkelgeschwindigkeiten nicht mehr ausreichend gewahrt.

- Bei sehr hohen Winkelbeschleunigungen sollte die adaptive Komponente ebenfalls deaktiviert werden, weil wiederum die Gültigkeit der Kennlinie beeinträchtigt ist.

Ergänzende Überlegungen

Bei den vorgesehenen einfachen Encodern besteht prinzipiell noch das Problem, daß auch deren Signale mit systematischen Fehlern behaftet sind, die zudem mit der Temperatur und Alterung stark driften. Zur Kompensation dieser Fehler wären folgende Verfahren verwendbar:

A. Verwendung der Mittelwerte zweier benachbarter Schaltpunkte SP eines Encoder-Kanals A statt der Schaltpunkte selbst; dadurch wird der größte Teil der (symmetrischen!) Drifts in einfacher Weise eliminiert (Fig. 6a). Dieses Verfahren wäre bei einer klassischen Regelung nicht anwendbar, weil der korrigierte Meßwert (Mittelwert einer vergangenen und einer zukünftigen Messung) erst zeitlich versetzt ermittelt werden kann. Als Winkelbasis für die Mitteilung kann z. B. der elektrische Winkel $T_{el}$ verwendet werden, dessen Auflösung im Sinne der Erfindung wesentlich über der des Encoders liegt. Die Anwendung dieses Verfahrens setzt voraus, daß die Teilung des Encoders nicht der Periode einer Abweichung oder einem Vielfachen davon entspricht.

B. Dieses Verfahren kann dahingehend modifiziert werden, daß aus der gemittelten Länge der High- bzw. Low-Perioden des Encoder-Signals ein Korrekturwert für die Flanken bestimmt und jeweils bei der Auswertung berücksichtigt wird (Figur 6b).

C. Als Verallgemeinerung dieser beiden einfachen Verfahren könnte bei geeigneter Abstimmung der Encoder-Teilung auf die Schrittwinkel des Motors ein Korrelationsverfahren angewendet werden, das aus einem überstrichenen Winkelbereich sowohl die Fehler des Schrittmotors als auch die des Encoders berechnet.

Theoretische Betrachtungen zum Ausführungsbeispiel

Im folgenden werden die theoretischen Grundlagen der Kompensation von periodischen Abweichungen bei Regelstrecken allgemein dargelegt.

Die Regelstrecke mit der Übertragungsfunktion $F_s$ setzt sich hier zusammen aus dem Schrittmotor 3 mit der Ansteuerung 2 und dem mechanischen System aus Welle, Zeiger 8 und Codescheibe 6 (vgl. Figur 1). Dabei resultieren die zu kompensierenden Nichtlinearitäten praktisch ausschließlich aus der Übertragungsfunktion des Motors 3.

Kennt man die Streckenübertragung $F_s$ hinreichend genau, kann theoretisch durch Vorschalten der inversen Streckenübertragung $F_s^{-1}$ die angestrebte Gesamt-Übertragung $T_m/T'_{el} \geq 1$ erzeugt werden. (Sofern nichts anderes angegeben, werden die Winkel $T_{el'}$, $T'_{el}$ in den Einheiten des mechanischen Winkels $T_m$ (esteps) ausgedrückt). Unter den oben gemachten Voraussetzungen ist eine Regelung im Grenzfall also nicht notwendig.

Da aber

- die Streckenübertragung nicht beliebig genau ermittelt werden kann

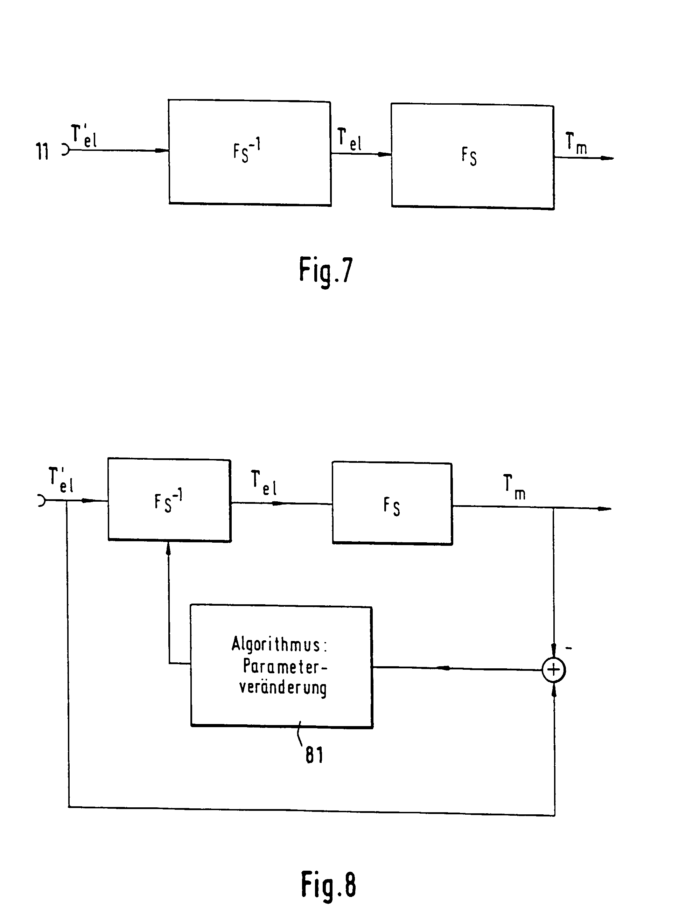

- unabhängig davon die inverse Streckenübertragung $F_s^{-1}$ nicht analytisch bestimmt bzw. zwar bestimmt, aber nicht exakt realisiert werden kann, die Eigenschaften von $F_s$ und damit von $F_s^{-1}$ sich zeitlich ändern können (z. B. Temperatureinflüsse, Alterung), wird in der praktischen Anwendung eine Rückführung notwendig, die im weitesten Sinn als Regelung bezeichnet werden kann (Fig. 8):

Daraus kann folgendes Vorgehensschema abgeleitet werden:

1) Aufnahme der Streckeneigenschaften

2) (Näherungsweise) Berechnung der inversen Streckenübertragung $F_s^{-1}$

3) Nachführung der Parameter von $F_s^{-1}$ anhand der Regelabweichung $T'_{el} - T_m$ im Betrieb mittels eines geeigneten Algorithmus.

# EP 0 739 501 B1

Für den betrachteten Dynamikbereich genügt eine hinreichend genaue Erfassung der statischen Winkelabweichung. Diese Kennlinie muß also erfaßt, daraus eine modifizierte Ansteuerung berechnet und ein Algorithmus zur Veränderung dieser Modifikation aus dem Betriebsverhalten angegeben werden.

Eine wichtige Randbedingung ist dabei, daß die modifizierte Ansteuerung $F_s^{-1}$ eine ausreichend geglättete Funktion ist, daß also zufällige Fehler ausgemittelt werden, da der Zeigerlauf sonst unnötig unruhig wird (Fig. 8).

Zur Erfüllung dieser Bedingungen wird die Fouriertransformierte der Winkelabweichung nach Fig. 12 berechnet. Da die Periodendauer der Grundschwingung und der Oberwellen bekannt ist, genügt die Entwicklung der Abweichung $\Delta T_m$ in eine Fourier-Reihe. Für eine Entwicklung bis zur K-ten Oberschwingung sind (2K + 1) Abtastwerte erforderlich. In einem Rechenprogramm werden N = 64 Abtastwerte pro elektrischer Periode aufgenommen, obwohl die Fourier-Reihe nur bis zur fünften Oberschwingung entwickelt wird. Dadurch wird eine Approximation der Kurve im Sinne der Methode der kleinsten Quadrate erzielt (Mittelung). Ein weiterer Grund für N = 64 liegt in der Reduzierung der erforderlichen Multiplikationen/Divisionen während des Programmablaufs. Der Fehler wird dabei in der Einheit 'esteps' angegeben. Aus der Abtastung einer elektrischen Periode wurde z. B. folgender Abtastsatz ermittelt:

| n | 0 | 1 | 2 | 3 | 4 | 5 | 6 | 7 | 8 | 9 | 10 | 11 | 12 | 13 | 14 | 15 |
|---|---|---|---|---|---|---|---|---|---|---|----|----|----|----|----|----|
| $\Delta T_m$ | 13 | 12 | 10 | 8 | 6 | 6 | 7 | 7 | 8 | 9 | 11 | 12 | 13 | 13 | 11 | 10 |

| n | 16 | 17 | 18 | 19 | 20 | 21 | 22 | 23 | 24 | 25 | 26 | 27 | 28 | 29 | 30 | 31 |
|---|----|----|----|----|----|----|----|----|----|----|----|----|----|----|----|----|
| $\Delta T_m$ | 8 | 5 | 3 | 2 | 0 | 0 | 1 | 3 | 5 | 8 | 9 | 11 | 13 | 14 | 15 | 15 |

| n | 32 | 33 | 34 | 35 | 36 | 37 | 38 | 39 | 40 | 41 | 42 | 43 | 44 | 45 | 46 | 47 |
|---|----|----|----|----|----|----|----|----|----|----|----|----|----|----|----|----|
| $\Delta T_m$ | 15 | 14 | 12 | 10 | 8 | 7 | 7 | 8 | 10 | 11 | 12 | 14 | 14 | 14 | 13 | 10 |

| n | 48 | 49 | 50 | 51 | 52 | 53 | 54 | 55 | 56 | 57 | 58 | 59 | 60 | 61 | 62 | 63 |
|---|----|----|----|----|----|----|----|----|----|----|----|----|----|----|----|----|
| $\Delta T_m$ | 8 | 7 | 3 | 1 | 0 | 0 | 1 | 2 | 5 | 7 | 9 | 12 | 14 | 15 | 15 | 14 |

(Für beide Drehrichtungen des Motors ist je ein Abtastsatz zu ermitteln).

Berechnung der Fourierkoeffizienten $a_k$, $b_k$ (= Fourieranalyse):

$$T_{el}(n) = n * 32$$

($T_{el}$ in ssteps, sin-Auflösung: 2048 ssteps)

$$a_k = 2/N * \sum_{n=0}^{N-1} \Delta T_m(n) * \cos(k * T_{el}(n))$$

für k = 0,1..K

$$b_k = 2/N * \sum_{n=0}^{N-1} \Delta T_m(n) * \sin(k * T_{el}(n))$$

für k = 1..K

N: Zahl der Abtastwerte
K: max. Oberwellenindex

Aus dem Beispielabtastsatz folgt damit:

| k | 0 | 1 | 2 | 3 | 4 |
|---|---|---|---|---|---|
| $a_k$ | 17,63 | −0,3880 | 2,871 | 0,2139 | 2,250 |
| $b_k$ | 0,0 | −0,3914 | 2,337 | −0,1496 | −4,675 |

| k | 5 | 6 | 7 | 8 | 9 |
|---|---|---|---|---|---|
| $a_k$ | −0,1199 | 0,2904 | −0,1558 | 0,2225 | −0,07786 |
| $b_k$ | −0,1392 | 0,4147 | −0,1018 | 0,1547 | −0,03751 |

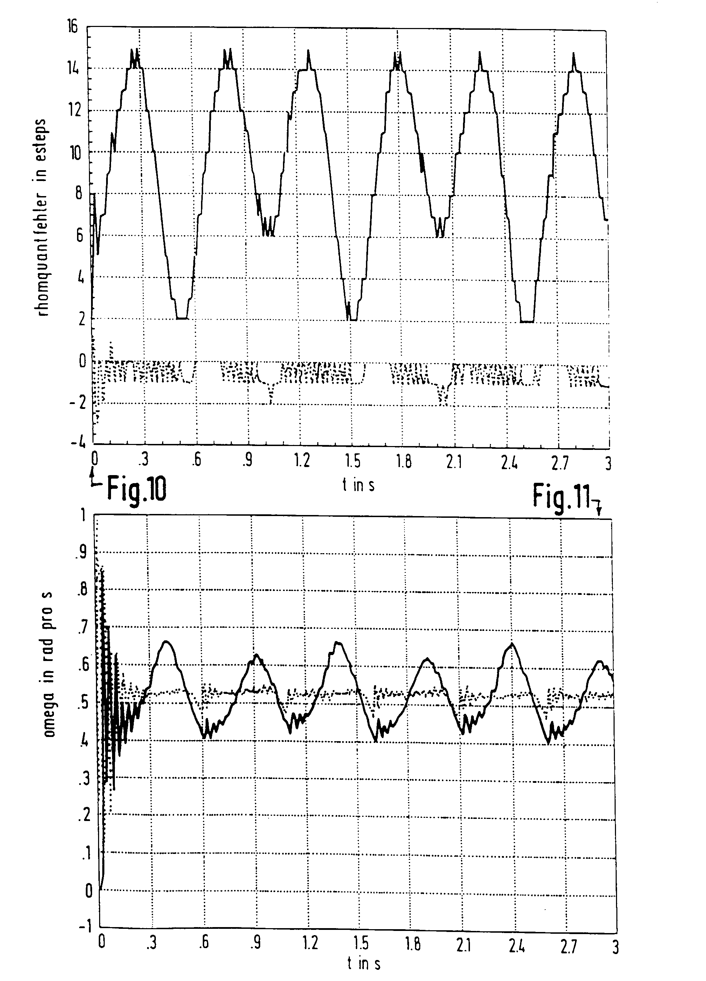

Zur Veranschaulichung ist in Figur 9 die Amplitude $c_k = \sqrt{(a_k^2 + b_k^2)}$ aufgetragen.

Die Rekonstruktion der periodischen Funktion $\Delta T_m (T_{el})$ ermöglicht Glchg. (4.2.1) (= Fouriersynthese):

$$\Delta T_m (T_{el}) = a_0/2 + \sum_{k=1}^{K} a_k * \cos(k * T_{el}) + \sum_{k=1}^{K} b_k * \sin(k * T_{el})$$

$$(4.2.1)$$

Für eine ausreichend genaue Rekonstruktion genügen dabei die Koeffizienten für die k-Werte 0, 2, 4, wie ein Vergleich der ursprünglichen mit der so rekonstruierten Abweichung (Figur 3) zeigt: Die gesamte Abweichungsinformation ist damit in den 5 Koeffizienten enthalten, die bei einer Realisierung als Programm entsprechend wenig RAM-Speicherplatz benötigen (5 Bytes bei Abspeicherung als signed char).

Ausgehend von der Abweichung kann nun eine modifizierte Ansteuerung ($F_s^{-1}$ angegeben werden:

Drückt man voraussetzungsgemäß den elektrischen Winkel in esteps aus, ergibt sich Gleichung (4.2.2):

$$T_m = T_{el} + \Delta T_m (T_{el}) \tag{4.2.2}$$

Gewünscht wird ein Gesamtverhalten des Motors, das beschrieben werden kann durch

$$T_m = T'_{el} \tag{4.2.3}$$

also ein proportionaler Zusammenhang zwischen dem (vorzugebenden) Winkel $T'_{el}$ und dem resultierenden Winkel $T_m$.

$$T'_{el} = T_{el} + \Delta T_m (T_{el}) \tag{4.2.4}$$

Aus einem vorzugebenden Winkel $T'_{el}$ müßte also aus (4.2.4) die tatsächliche Ansteuerung $F_{el}$ ermittelt werden, dann wäre Gleichung (4.2.3) erfüllt. Dies erfordert die Berechnung der Umkehrfunktion zu (4.2.4).

$$T'_{el} = f(T_{el}) \rightarrow T_{el} = f^{-1}(T'_{el})$$

Die UF existiert zwar, (Eineindeutigkeit), kann aber analytisch nicht bestimmt werden.
Eine Näherungslösung könnte z. B. mit iterativen Verfahren berechnet werden.
Im Hinblick auf eine Realisierung ist dieses rechen- und damit zeitintensive Verfahren wenig geeignet. Günstiger erscheint deshalb eine Näherungslösung, bei der gesetzt wird:

$$\Delta T_m \, (T_{el}) \approx \Delta T_m \, (T'_{el}) \qquad\qquad (4.2.5)$$

damit folgt aus Glchg. (4.2.4)

$$T'_{el} = T_{el} + \Delta T_m \, (T'_{el}) \qquad\qquad (4.2.6)$$

Bei gegebenem $T'_{el}$ kann damit der Ansteuerwert $T_{el}$ auf einfache Weise berechnet werden. Da für diese Ansteuerung aber nicht die UF berechnet wird, erzeugt dieses Verfahren einen prinzipiellen Restfehler:
Glchg. (4.2.2):

$$T_m = T_{el} + \Delta T_m \, (T_{el})$$

Einsetzen von Glchg. (4.2.6):

$$T_m = T'_{el} - \Delta T_m \, (T'_{el}) + \Delta T_m(T'_{el} - \Delta T_m(T'_{el})) \qquad\qquad (4.2.7a)$$

also:

$$T_m = T'_{el} + rf \, (T'_{el}) \qquad\qquad (4.2.7b)$$

neben dem gewünschten Proportionalterm $T'_{el}$ tritt also auf der rechten Seite der Glchg. (4.2.7) noch der Restfehler rf $(T'_{el})$ auf:

$$rf(T'_{el}) = -\Delta T_m(T'_{el}) + \Delta T_m(T'_{el} - \Delta T_m(T'_{el}))$$

rf $(T'_{el})$ kommt also dadurch zustande, daß die Fehlerfunktion $\Delta T_m \, (T_{el})$ einerseits an der Stelle $T'_{el}$, andererseits an der modifizierten Stelle $T'_{el} - \Delta T_m(T'_{el})$ ausgewertet und die Differenz der beiden Funktionswerte gebildet wird.

$$\rightarrow rf(T'_{el}) \ll \Delta T_m \, (\Delta T'_{el}),$$

womit die prinzipielle Tauglichkeit des Verfahrens gezeigt ist. Aufschlüsse über die Güte des Verfahrens können mit Hilfe einer Simulation gewonnen werden. In den Figuren 10 und 11 sind die Matrix-Simulationsergebnisse für den Winkelfehler sowie für die Winkelgeschwindigkeit ($W_{soll}$ = 0,5rad/s) bei korrigierter und nicht-korrigierter Ansteuerung aufgetragen.

<u>Adaptive Komponente</u>

Das zuletzt besprochene Verfahren geht von der Annahme aus, daß die Winkelfehlerkennlinie - auch über längere Zeiträume - konstant bleibt. Bei einem realen Motor besteht jedoch die Möglichkeit, daß sich die Kurve infolge verschiedener Einflüsse (z. B. Temperatur, Alterung) ändert. Um die Ansteuerung immer optimal zu halten, muß diese Änderung berücksichtigt werden. Dafür bieten sich prinzipiell 2 Möglichkeiten an.

1) gesteuerte Nachführung der Koeffizienten $a_k$, $b_k$
Kennt man alle relevanten Einflüsse sowie die Abhängigkeit der Fehlerkurve von diesen Einflüssen, kann eine gesteuerte Nachführung der Koeffizienten $a_k$, $b_k$ durch Sensordaten erfolgen (z. B. Temperaturfühler), die eventuell ohnehin vorliegen.

2) Echtzeiterfassung und -verarbeitung der verbleibenden
Fehlerkurve, die sich bei Ansteuerung mit den korrigierten Werten ergibt, wodurch eine ständige Modifikation der Koeffizienten $a_k$, $b_k$ erfolgt.
Vorschlag 2 entspricht der vorliegenden Erfindung gemäß Figur 5, die regelungstechnische Struktur zeigt (Figur 8). Bei der Realisierung müssen verschiedene Aspekte berücksichtigt werden:

1) Es ist im Betrieb nicht möglich, periodisch eine Neuaufnahme der Fehlerkennlinie durchzuführen, da dies die Ansteuerung mit nicht korrigierten Werten bedeuten würde.

2) Im Betrieb ist ständig eine Drehrichtungsumkehr möglich, d. h. es kann auch bei korrigierter Ansteuerung nicht davon ausgegangen werden, daß eine elektrische Periode vollständig durchlaufen und daraus eine Gesamt-Korrektur errechnet werden kann.
Vielmehr müssen einzelne, isolierte Meßwerte der Regelabweichung so verarbeitet werden, daß sich eine Nachführung der
Ansteuerkorrektur ergibt.
Dazu wird folgendes Verfahren vorgeschlagen:
Wenn im Betrieb ein elektrischer Winkel angesteuert wird, bei dem bei der ursprünglichen Aufnahme der Fehlerkurve ein Abtastwert gebildet wurde, wird zunächst die Regelabweichung diff = $T'_{el}$ - $T_m$ (in esteps) gebildet. Sei n der Index des Abtastwertes, 1 die Laufvariable für den Zustand nach der 1-ten Änderung, dann gilt:

$$\Delta T_m(n)^{i+1} \approx \Delta T_m(n)^i + \text{diff}(n)$$

entsprechend obigen Überlegungen.
Daraus folgt die Modifikation des k-ten Koeffizienten durch den n-ten Abtastwert:

$$a_k^{i+1} = a_k^i +$$

$$2/N*(-\Delta T_m(n)^i*\cos(k*T_{el}(n)) + \Delta T_m(n)^{i+i}*\cos(k*T_{el}(n)) =$$

$$a_k^i + 2/N* \text{diff}(n) * \cos(k*T_{el}(n)) \tag{4.2.8a}$$

entsprechend gilt für $b_k^{i+1}$:

$$b_k^{i+1} = b_k^i + Z/N \, (\text{diff}(n)*\sin(k*T_{el}(n))) \tag{4.2.8b}$$

Die Kenntnis des letzten Fehlerwertes $\Delta T_m(n)^1$ ist also nicht notwendig.
Damit sind einfache Verfahren zur Modifikation der Koeffizienten $a_k$, $b_k$, gefunden.
Durch günstige Wahl von Parametern und Skalierungsfaktoren können im Programm ADAP zwei der drei in Glchg. (4.2.8a, b) vorhandenen Multiplikationen sowie die Division eingespart werden. Zum Nachweis der Tauglichkeit des Verfahrens können im Programm alle Koeffizienten $a_k$, $b_k$ sowie alle Abtastwerte mit 0 vorbelegt werden, wodurch sich anfänglich eine Ansteuerung mit nicht korrigierter Kurve ergibt. Im Verlauf des Durchfahrens einiger elektrischer Perioden werden die Koeffizienten $a_k$, $b_k$ und damit die modifizierte Ansteuerung $F_s^{-1}$ vom Programm selbsttätig ermittelt, der Zeigerlauf ist dann identisch wie bei Durchführung des ursprünglichen Verfahrens, bei dem zunächst die Fehlerkurve insgesamt abgetastet und fouriertransformiert wurde und damit das Adaptationsverfahren erst bei Ansteuerung mit bereits korrigierten Werten wirksam werden konnte.
Abschließend sei noch einmal darauf hingewiesen, daß grundlegend das betrachtete Adaptationsverfahren für einen niedrigeren Dynamikbereich verwendbar ist. Wird der Motor in einem höheren Dynamikbereich betrieben, gewinnen die dynamischen Momente zunehmend Einfluß auf das Motorverhalten und dürfen deshalb nicht mehr unberücksichtigt bleiben. Für diesen Bereich sollte deshalb der adaptive Teil des Verfahrens stillgelegt werden.

# EP 0 739 501 B1

## Patentansprüche

1. Verfahren zur Mikroschrittansteuerung eines Schrittmotors (3), vorzugsweise eines Klauenpol-Schrittmotors, mit einer Steuerung (1), die Strom- bzw. Spannungsimpulse als Impulsfolge mit sinusähnlichem Verlauf an den Schrittmotor (3) abgibt, wodurch sich der Rotor des Schrittmotors (3) in Mikroschritten weiterdreht, wobei der mechanische Drehwinkel ($T_m$) des Schrittmotors (3) mittels eines Winkelgebers (Encoders) (4) erfaßt wird, und wobei die Steuerung (1) die Differenz ($\Delta T_m$) zwischen dem elektrischen Phasenwinkel ($T_{el}$) und dem mechanischen Drehwinkel ($T_m$) des Schrittmotors (3) bildet und wobei die Steuerung (1) aus der Differenz ($\Delta T_m$) nach einem vorgegebenen Algorithmus ein korrigiertes Signal für den Schrittmotor (3) bildet, dadurch gekennzeichnet, daß die Steuerung (1) zur Korrektur zunächst Fourier-Koeffizienten bildet, wobei die Differenzen ($\Delta T_m$) mehrerer elektrischer Zyklen des Schrittmotors (3) zur Ermittlung der Fourier-Koeffizienten für einen elektrischen Zyklus des Schrittmotors (3) dienen und wobei die Steuerung (1) dann unter Einbeziehung dieser Fourier-Koeffizienten das korrigierte Signal für den Schrittmotor (3) bildet, das für den weiteren Betrieb des Schrittmotors (3) verwendet wird.

2. Verfahren nach Anspruch 1 oder 2, dadurch gekennzeichnet, daß die Korrektur-Koeffizienten Fourier-Koeffizienten der Differenz ($\Delta T_m$) umfassen.

3. Verfahren nach Anspruch 2, dadurch gekennzeichnet, daß die Fourier-Koeffizienten für die zweite und die vierte Harmonische der Differenz ($\Delta T_m$) gebildet werden.

4. Verfahren nach einem der Ansprüche 1 bis 3, dadurch gekennzeichnet, daß die Steuerung (1) die Fourier-Koeffizienten in einen Speicher (41) schreibt.

5. Verfahren nach Anspruch 4, dadurch gekennzeichnet, daß die Fourier-Koeffizienten einmalig bestimmt und in den Speicher (41) der Steuerung (1) abgelegt werden.

6. Verfahren nach einem der Ansprüche 1 bis 5, dadurch gekennzeichnet, daß der Winkelgeber (4) einen Nullpunkt des Schrittmotors (3) erfaßt.

7. Verfahren nach einem der Ansprüche 1 bis 6, dadurch gekennzeichnet, daß die Steuerung zusätzlich Fourier-Koeffizienten für die Kompensation der Hysterese des Schrittmotors (3) bildet.

8. Verfahren nach Anspruch 7, dadurch gekennzeichnet, daß die Fourier-Koeffizienten für die Kompensation der Hysterese unter Verwendung der Meßdaten des Winkelgebers (4) während des Betriebs verändert werden.

9. Verfahren nach einem der vorhergehenden Ansprüche, dadurch gekennzeichnet, daß das Verfahren für einen Schrittmotor (3) für ein Anzeigegerät vorzugsweise in einem Kraftfahrzeug verwendet wird.

## Claims

1. Method for the microstep driving of a stepping motor (3), preferably a claw-pole stepping motor, having a controller (1) which outputs current or voltage pulses as a pulse train with a form similar to a sine wave to the stepping motor (3), as a result of which the rotor of the stepping motor (3) rotates further in microsteps, the mechanical angle of rotation ($T_m$) of the stepping motor (3) being registered by means of an angle encoder (4), and the controller (1) forming the difference ($\Delta T_m$) between the electric phase angle ($T_{el}$) and the mechanical angle of rotation ($T_m$) of the stepping motor (3), and the controller (1) forming a corrected signal for the stepping motor (3) from the difference ($\Delta T_m$) in accordance with a predefined algorithm, characterized in that, for the correction, the controller (1) firstly forms Fourier coefficients, the differences ($\Delta T_m$) from several electric cycles of the stepping motor (3) being used to ascertain the Fourier coefficients for one electric cycle of the stepping motor (3), and the controller (1) then including these Fourier coefficients when forming the corrected signal which is intended for the stepping motor and is used for the further operation of the stepping motor (3).

2. Method according to Claim 1, characterized in that the correction coefficients comprise Fourier coefficients of the difference ($\Delta T_m$).

3. Method according to Claim 2, characterized in that the Fourier coefficients for the second and the fourth harmonics of the difference ($\Delta T_m$) are formed.

10

4. Method according to one of Claims 1 to 3, characterized in that the controller (1) writes the Fourier coefficients into a memory (41).

5. Method according to Claim 4, characterized in that the Fourier coefficients are determined once and are stored in the memory (41) of the controller (1).

6. Method according to one of Claims 1 to 5, characterized in that the angle encoder (4) registers a zero point of the stepping motor (3).

7. Method according to one of Claims 1 to 6, characterized in that the controller additionally forms Fourier coefficients for compensating for the hysteresis of the stepping motor (3).

8. Method according to Claim 7, characterized in that the Fourier coefficients for compensating for the hysteresis are changed during operation, using the measured data from the angle encoder (4).

9. Method according to one of the preceding claims, characterized in that the method is used for a stepping motor (3) for an indicating device, preferably in a motor vehicle.


**Revendications**

1. Procédé de commande d'un moteur pas à pas (3) par des micropas, notamment d'un moteur pas à pas à griffe polaire, comprenant une commande (1) qui fournit des impulsions de courant ou de tension comme suite d'impulsions à forme analogue à une forme sinusoïdale pour le moteur pas à pas (3), pour faire tourner le rotor du moteur pas à pas (3) suivant des micropas,

selon lequel on détecte l'angle de rotation mécanique ($T_m$) du moteur pas à pas (3) à l'aide d'un capteur d'angle (codeur) (4),
et la commande (1) forme la différence ($\Delta T_m$) entre l'angle de phase électrique ($T_{el}$) et l'angle de rotation mécanique ($T_m$) du moteur pas à pas,
et à partir de la différence ($\Delta T_m$) la commande forme selon un algorithme prédéterminé, un signal corrigé pour le moteur pas à pas (3),

caractérisé en ce que

- la commande (1) forme tout d'abord des coefficients de Fourier pour la correction,
- la différence ($\Delta T_m$) de plusieurs cycles électriques du moteur pas à pas (3) servant à déterminer les coefficients de Fourier d'un cycle électrique du moteur pas à pas (3) et
- la commande (1) forme le signal corrigé pour le moteur pas à pas en tenant compte des coefficients de Fourier, ce signal étant alors utilisé pour la poursuite du fonctionnement du moteur pas à pas (3).

2. Procédé selon la revendication 1,
caractérisé en ce que

les coefficients de correction correspondent aux coefficients de Fourier de la différence ($\Delta T_m$).

3. Procédé selon la revendication 2,
caractérisé en ce qu'

on forme les coefficients de Fourier pour la seconde et la quatrième harmonique de la différence ($\Delta T_m$).

4. Procédé selon l'une des revendications 1 à 3,
caractérisé en ce que

la commande (1) enregistre les coefficients de Fourier dans une mémoire (41).

5. Procédé selon la revendication 4,
caractérisé en ce qu'

on détermine une seule fois les coefficients de Fourier et on les inscrit dans la mémoire (41) de la commande (1).

6. Procédé selon l'une des revendications 1 à 5, caractérisé en ce que

    le capteur d'angle (4) détecte un point (O) du moteur pas à pas (3).

7. Procédé selon l'une quelconque des revendications 1 à 6, caractérisé en ce que

    la commande forme en outre des coefficients de Fourier pour la compensation de l'hystérésis du moteur pas à pas (3).

8. Procédé selon la revendication 7, caractérisé en ce que

    les coefficients de Fourier sont modifiés pendant le fonctionnement en utilisant les données de mesure du capteur d'angle (4) pour compenser l'hystérésis.

9. Procédé selon l'une des revendications précédentes, caractérisé en ce qu'

    il est appliqué à un moteur pas à pas (3) pour un appareil d'affichage de préférence dans un véhicule automobile.

Fig.1

Fig.2

Fig.3

Fig.4

Fig.5

Fig. 9

Fig.6a

Fig.6b

Fig.7

Fig.8

Fig.10

Fig.11